# EUROPEAN PATENT SPECIFICATION

(11) **EP 3 830 864 B1**
(45) Date of publication and mention of the grant of the patent: **03.01.2024**
(21) Application number: 19752602.3
(22) Date of filing: 26.07.2019
(51) Int. Cl.: H01L 21/67

(54) **DETACHABLE THERMAL LEVELER**
ABNEHMBARER WÄRMENIVELLIERER
DISPOSITIF DE MISE À NIVEAU THERMIQUE DÉTACHABLE

(30) Priority: 01.08.2018 US 201862713169 P
(43) Date of publication of application: 09.06.2021
(73) Proprietor: Momentive Performance Materials Inc., Waterford, NY 12188 (US)
(72) Inventor: NATARAJAN, Sudarshan, Solon, Ohio 44139 (US); FAN, Wei, Brecksville, Ohio 44141 (US); LIU, Xiang, Medina, Ohio 44256 (US); SHAFFER, Gregory, Strongsville, Ohio 44136 (US)
(74) Representative: Müller-Boré & Partner Patentanwälte PartG mbB
(86) International application number: PCT/US2019/043579
(87) International publication number: WO 2020/028156

(56) References cited:
- WO-A1-2018/064308
- GB-A- 2 352 508
- US-A- 5 025 133
- US-A1- 2010 326 645

## Description

### CROSS-REFERENCE TO RELATED APPLICATIONS

The present application claims priority to and the benefit of U.S. Provisional Patent Application No. 62/713,169 titled "Detachable Thermal Leveler" filed on August 1, 2018.

### FIELD OF INVENTION

The present invention relates to an apparatus comprising a thermal leveler. In particular, the present invention relates to an apparatus with a thermal leveler that is detachable and removable from the apparatus.

### BACKGROUND

Thermal pyrolytic graphite (TPG) based thermal levelers or spreaders are used in various heat dissipating, leveling, spreading, and focusing applications along with a heater or cooler. The goal of using these levelers is to achieve a desired temperature profile utilizing the enhanced thermal conductivity of the TPG material. These levelers can be in the form of either naked TPG or an encapsulated TPG structure, i.e., TPG encapsulated by a metal, semimetal, ceramic or alloy such as, for example, aluminum, copper, stainless steel, silicon, aluminum nitride, aluminum oxide or tungsten-copper respectively. TPG based thermal spreaders are typically used to cool the high-end electronics to improve the reliability of the system. In such applications, the thermal spreaders provides undiminished performance over the lifetime of the system, hence the thermal spreader is part of the capital expenditure.

TPG based thermal levelers are used in the production of semiconductor equipment. Many semiconductor processes are typically performed in a vacuum environment, i.e., a sealed chamber containing an assembly for supporting the wafer substrate(s) disposed therein. In a semiconductor process, a heating apparatus typically includes a ceramic support that may have electrodes disposed therein to heat the support, and additionally may have electrodes that electrostatically hold the wafer or substrate against the ceramic support, i.e., electrostatic chuck or ESC (also sometimes called susceptors). A semiconductor device fabrication process can take place in the chamber, including deposition, etching, implantation, oxidation, etc. As an example of a deposition process is a physical vapor deposition (PVD) process, known as sputter deposition, in which a target generally comprised of a material to be deposited on the wafer substrate is supported above the substrate, typically fastened to a top of the chamber. Plasma is formed from a gas such as argon supplied between the substrate and the target. The target is biased causing ions within the plasma to be accelerated toward the target. The ions of the plasma interact with the target material, and cause atoms of the material to be sputtered off, travel through the chamber toward the wafer, and redeposit on the surface of a semiconductor wafer that is being processed into integrated circuits (IC's). Other deposition processes may include, but are not limited to, plasma enhanced chemical vapor deposition (PECVD), high density plasma chemical vapor deposition (HDP-CVD), low pressure chemical vapor deposition (LPCVD), sub-atmospheric pressure chemical vapor deposition (SACVD), metal organic chemical vapor deposition (MOCVD), molecular beam evaporation (MBE), etc.

In some of the above processes it is desirable to heat the wafer by heating the support. In some of the other cases, heat generated on the wafer due to the process needs to be removed. The chemical reaction rate of the materials being deposited, etched, implanted, etc., is controlled to some degree by the temperature of the wafer. Undesirable unevenness in deposition, etching, implantation, etc., over a face of the wafer can easily result if the temperature of the wafer across its area varies too much. In most cases, it is highly desirable that deposition, etching, implantation be uniform to a nearly perfect degree since otherwise the IC's being fabricated at various locations on the wafer will have electronic characteristics that deviate from the norm more than is desirable.

In these applications, the thermal leveler helps to dissipate the heat in the lateral direction and improve the temperature distribution across the entire wafer. The thermal leveler, however, is exposed to corrosive process chemistries. This corrosive environment wears the thermal leveler or the component containing the leveler, thus the leveler or the component containing the leveler becomes "consumable," i.e. the leveler needs to be replaced with a newly made component as the performance deteriorates. Replacement can be initiated by diminished performance of the thermal leveler or failure of some other sub-components of the component such as the heater or corrosion of the leveler encapsulating the thermal leveler causing contamination or particle generation. Corrosion of the encapsulating layers of the leveler can also cause pitting and/or can push the flatness out of specification. These mechanisms can diminish the thermal performance of the leveler by inducing poorer contact with the wafer/substrate. Although replacing the old & worn leveler with a newly made leveler or a newly made component with the leveler works technically, it is not a viable solution economically, as the cost of manufacturing the leveler is very high. Cost of the leveler is high because of the number of batch processes involved in the manufacturing process. Manufacturing involves multiple steps of bonding, machining, lapping, and finishing. In addition to these processes, the TPG material cost is high because of batch processes such as CVD and high temperature treatment.

The following documents are cited as being relevant illustrations of the prior art:

WO 2018/064308 A1 discloses a heating apparatus used in semiconductor processing device;

US 5025133 A discloses a semiconductor wafer heating device including a hollow heating stage;

GB 2352508 A discloses a method and apparatus for heating a wafer, and also baking a photoresist on a wafe

### SUMMARY

The following presents a summary of this disclosure to provide a basic understanding of some aspects. This summary is intended to neither identify key or critical elements nor define any limitations of embodiments or claims. Furthermore, this summary may provide a simplified overview of some aspects that may be described in greater detail in other portions of this disclosure.

Provided is an apparatus suitable for supporting a substrate in a process chamber or other application and providing a desired thermal leveling profile. The apparatus is configured to provide a thermal leveler that is detachable from the apparatus. As such, the thermal leveler may be removed from the apparatus when a portion of the apparatus, e.g., an outer surface of the apparatus, has been deteriorated (e.g., corroded, consumed, etc.) to a point that the performance of the apparatus makes it no longer suitable for use. The thermal leveler can be removed from the apparatus and reused by transferring to another apparatus to provide a desired thermal leveling profile.

In one aspect, provided is an apparatus for supporting a substrate comprising a cover plate having an upper surface for supporting a substrate and a lower surface opposite the upper surface, and a thermal leveler comprising thermal pyrolytic graphite, the thermal leveler disposed adjacent to the lower surface of the cover plate and detachable from the coverplate.

In one aspect, provided is an apparatus comprising a thermal leveler releasably associated with a cover plate.

In one embodiment, the thermal leveler is releasably associated with the cover plate via a clamp, a bolt, a thread, a cam lock, a retaining groove, a retaining ring, a spring, a vacuum, electrostatic forces, electromagnetic forces, magnetic forces, an adhesive, a solder, or a paste.

In one embodiment, the thermal leveler is disposed between the cover plate and the base plate.

In one embodiment, the thermal leveler is detachably associated with the base plate.

In on embodiment, the base plate comprises a lower surface, one or more sidewalls extending around the perimeter of the base plate, and an opening defined between the one or more side walls, the thermal leveler disposed within the opening, and the one or more sidewalls having a threaded surface adjacent an upper end of the one or more sidewalls; wherein the cover plate is sized to fit within the opening of the base plate and includes a threaded side surface to engage the threaded surface of the base plate.

In one embodiment, the base plate comprises an upper surface, a lower surface, and a threaded side surface, the upper surface supporting the thermal leveler; the cover plate includes an upper surface, and one or more side walls extending downwardly from the upper surface of the cover plate and extending around the perimeter thereof, and an opening defined between the one or more side walls and sized to surround the thermal leveler and the base plate, wherein the one or more walls of the cover plate include a threaded surface to engage the threaded surface of the base plate.

In one embodiment, the cover plate includes one or more apertures; the thermal leveler includes one more apertures aligned with the one or more apertures of the cover plate; and the base plate includes one or more recesses aligned with the one or more apertures of the thermal leveler, wherein the cover plate, thermal leveler, and base plate are releasably connected to one another via fasteners disposed through the one or more apertures of the cover plate and the thermal leveler and the recesses of the base plate

In one embodiment, at least one of the fasteners is a pin that locks into one of the one or more recesses of the base plate

In one embodiment, at least one of the one or more recesses in the base plate has a threaded surface, and at least one of the fasteners is a threaded fastener suitable for threaded engagement of the at least one or more recesses with the threaded surface.

In one embodiment, an upper surface of the thermal leveler includes a recess, and a lower surface of the cover plate includes a projection aligned with and sized to mate with the recess in the upper surface of the thermal leveler.

In one embodiment,the thermal leveler comprises thermal pyrolytic graphite.

In one embodiment, the thermal leveler comprises a sheet of thermal pyrolytic graphite disposed between an upper sheet and a lower sheet.

In one embodiment, the thermal leveler is encapsulated by a cover layer.

In one embodiment, the upper sheet, the lower sheet, or the cover layer are independently chosen from a metal or ceramic material.

In one embodiment, the upper sheet, the lower sheet, or the cover layer are independently chosen from aluminum, copper, silver, gold, nickel, beryllium, tin, lead, steel, a steel alloy, copper-tungsten, copper-molybdenum, Invar, aluminum-beryllium, tin-lead; an oxide, nitride, carbide, carbonitride or oxynitride of elements selected from a group consisting of B, Al, Si, Ga, Y, refractory hard metals, transition metals.

In one embodiment, the thermal leveler comprises plural sheets of thermal pyrolytic graphite.

In one embodiment, the plural sheets of thermal pyrolytic graphite with graphene basal planes parallel or perpendicular to the substrate surface.

In one embodiment, the apparatus comprises a plurality of thermal levelers.

In one embodiment, the plurality of thermal levelers comprises thermal pyrolytic graphite with graphene basal planes parallel or perpendicular to the substrate surface.

In one embodiment, the base plate includes a heater and/or a cooler.

In one embodiment, the apparatus comprises an electrode disposed therein.

In another aspect, provided is a process for heating or cooling a substrate comprising heating or cooling a substrate disposed on the upper surface of the cover plate of any of the previous embodiments.

In one embodiment, the process comprises heating the substrate to an end point, removing the substrate from the apparatus, releasing the cover plate from the thermal leveler, providing a fresh cover plate and releasably connecting it to the thermal leveler, and providing a second substrate to the apparatus and heating the second substrate.

The following description and the drawings disclose various illustrative aspects. Some improvements and novel aspects may be expressly identified, while others may be apparent from the description and drawings.

### BRIEF DESCRIPTION OF THE DRAWINGS

The accompanying drawings illustrate various systems, apparatuses, devices and related methods, in which like reference characters refer to like parts throughout, and in which:
Figure 1 is a perspective view showing an embodiment of a heating apparatus;
Figure 2 is a cross sectional view of one embodiment of an apparatus comprising a detachable thermal leveler;
Figure 3 is a cross sectional view of one embodiment of an apparatus comprising a detachable thermal leveler;
Figure 4a is a cross sectional view of one embodiment of an apparatus comprising a detachable thermal leveler;
Figure 4b is a cross sectional view of one embodiment of an apparatus comprising a detachable thermal leveler;
Figure 5 is a cross sectional view of one embodiment of an apparatus comprising a detachable thermal leveler;
Figure 6 is a cross sectional view of one embodiment of an apparatus comprising a detachable thermal leveler;
Figure 7 is a cross sectional view of one embodiment of an apparatus comprising a detachable thermal leveler;
Figures 8a-8d show cross sectional views of embodiments of thermal levelers;
Figures 9a-9c show a top view of embodiments of thermal levelers;
Figure 10 shows a cross sectional view of an embodiments of a thermal levelers.

### DETAILED DESCRIPTION

Reference will now be made to exemplary embodiments, examples of which are illustrated in the accompanying drawings. It is to be understood that other embodiments may be utilized and structural and functional changes may be made. Moreover, features of the various embodiments may be combined or altered. As such, the following description is presented by way of illustration only and should not limit in any way the various alternatives and modifications that may be made to the illustrated embodiments. In this disclosure, numerous specific details provide a thorough understanding of the subject disclosure. It should be understood that aspects of this disclosure may be practiced with other embodiments not necessarily including all aspects described herein, etc.

As used herein, the words "example" and "exemplary" means an instance, or illustration. The words "example" or "exemplary" do not indicate a key or preferred aspect or embodiment. The word "or" is intended to be inclusive rather than exclusive, unless context suggests otherwise. As an example, the phrase "A employs B or C," includes any inclusive permutation (e.g., A employs B; A employs C; or A employs both B and C). As another matter, the articles "a" and "an" are generally intended to mean "one or more" unless context suggest otherwise.

As used herein, the "heating apparatus," may be used interchangeably with "treating apparatus," "heater," "electrostatic chuck," "chuck," or "processing apparatus," "pedestal," upper or bottom electrode, referring to an apparatus containing at least one heating and/or cooling element to regulate the temperature of the substrate supported thereon, specifically, by heating or cooling the substrate.

As used herein, the term "substrate" refers to the semiconductor wafer or the glass mold being supported/heated by the processing apparatus of the invention. As used herein, the term "sheet" may be used interchangeably with "layer."

As used herein, the term "circuit" may be used interchangeably with "electrode," and the term "heating element" may be used interchangeably with "heating electrode," "electrode," "resistor," "heating resistor," or "heater." The term "circuit" may be used in either the single or plural form, denoting that at least one unit is present.

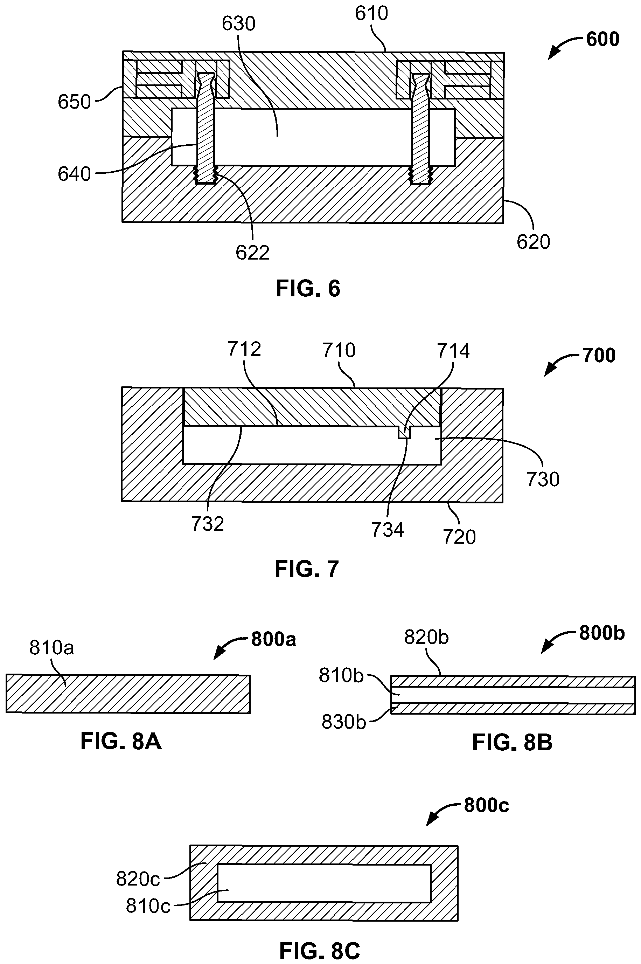

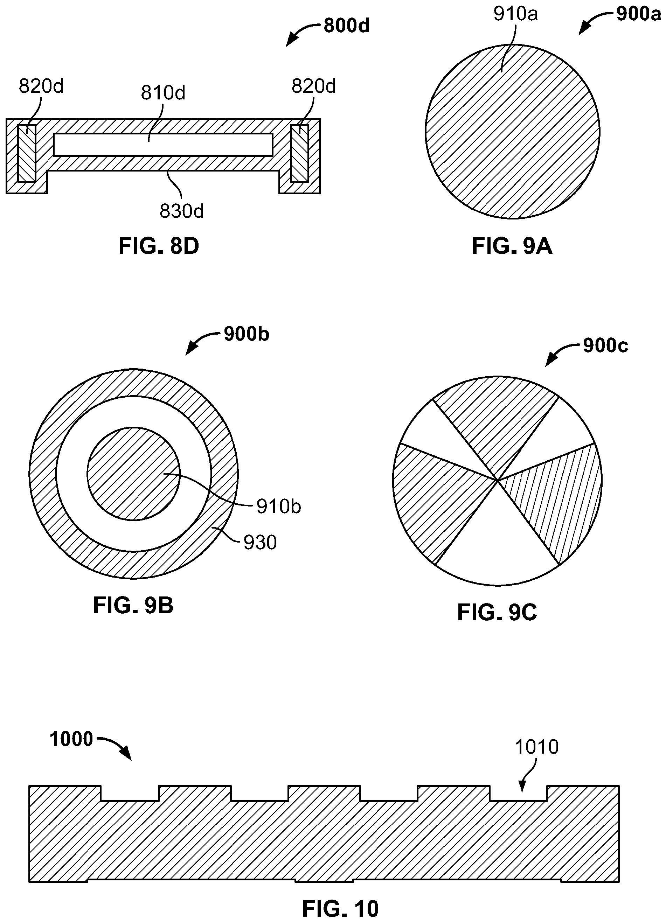

A thermal leveler may have multiple zones. Temperatures of different zones can be different based on the configuration and layout of TPG (as exemplified in fig 8 and 9) and the layout and location of the heaters and coolers relative to TPG. As used herein, thermal uniformity or relatively uniform temperature means that the difference between the maximum and minimum temperature points over a certain length with in the zone. Thermal uniformity within the zone is critical and this may range from 3% over 300mm to less than 0.5% over 300mm.

In a plasma chamber for processing substrates such as semiconductor wafers or glass lenses, the substrate temperature significantly affects the process. For a processing apparatus to uniformly regulate the temperature of the substrate being treated, it is desirable for the apparatus to provide temporal and spatial control of the surface temperature of the substrate. Graphite is an anisotropic material with a unique ability to direct heat in a preferred direction. Thermal pyrolytic graphite (TPG) is a unique graphite material consisting of crystallites of considerable size, the crystallites being highly aligned or oriented with respect to each other and having well ordered carbon layers or a high degree of preferred crystallite orientation. TPG may be may be used interchangeably with "highly oriented pyrolytic graphite" ("HOPG"), or compression annealed pyrolytic graphite ("CAPG"). TPG is extremely thermally conductive with an in-plane (a-b direction) thermal conductivity greater than 1000 W/m-K, while the thermal conductivity in the out-of-plane (z-direction) is in the range of 5 to 30 W/m-K. In one embodiment, TPG has an in-plane thermal conductivity greater than 1,500 W/m-K.

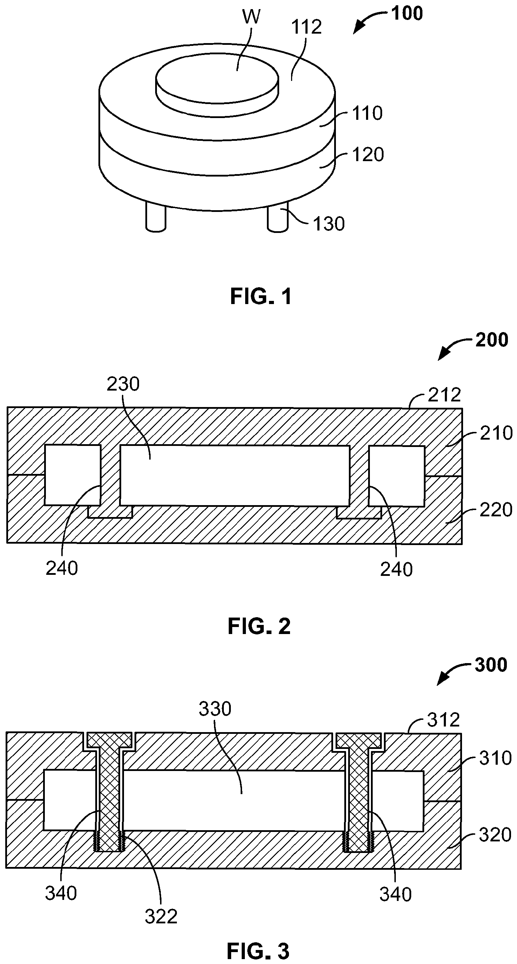

In one embodiment, the heating apparatus 100 is as illustrated in FIG. 1, comprising a disk-shaped metallic or ceramic substrate having an electrode buried therein (not shown), whose top surface 112 serves as a supporting surface for a substrate, e.g., a wafer W. In one embodiment, the top surface 112 is made of a high degree of flatness (within 0.05 mm surface variation) to further enhance the temperature control of the substrate W. Electric terminals 130 for supplying electricity to the heating resistor can be attached at the center of the bottom surface of the substrate, or in one embodiment, at the sides of the substrate.

In one embodiment, the top surface 112 is relatively uniform in temperature, i.e., the difference between a maximum and a minimum temperatures on the top surface is less than 10° C. In a second embodiment, the temperature difference is less than 5° C. In temperature uniformity of the top surface 112 corresponds to a uniform temperature of the substrate W being heated. In one embodiment, the substrate W has a maximum temperature variation of 5° C., and in a second embodiment a maximum temperature variation of 2° C.

In the heater apparatus, one or more electrodes can be employed. Depending on the application, the electrode may function as a resistive heating element, a plasma-generating electrode, an electrostatic chuck electrode, or an electron-beam electrode. The electrode can be embedded within the substrate of the heater toward the top (near the wafer substrate) or the bottom (away from the wafer substrate). A bottom location may help diffuse the pattern of the electrode and assist in the heat distribution to the wafer substrate.

In one embodiment, the electrode is in the form of a film electrode and formed by processes known in the art including screen-printing, spin coating, plasma spray, spray pyrolysis, reactive spray deposition, sol-gel, combustion torch, electric arc, ion plating, ion implantation, sputtering deposition, laser ablation, evaporation, electroplating, and laser surface alloying. In one embodiment, the film electrode comprises a metal having a high melting point, e.g., tungsten, molybdenum, rhenium and platinum or alloys thereof. In another embodiment, the film electrode comprises at least one of carbides or oxides of hafnium, zirconium, cerium, and mixtures thereof.

In another embodiment, the electrode layer is in the form an elongated continuous strip of pyrolytic graphite. Pyrolytic graphite ("PG") is first deposited onto a heater base, e.g., pyrolytic boron nitride coated graphite base, via processes known in the art such as chemical vapor deposition. The PG is then machined into a pre-determined pattern, e.g., a spiral, a serpentine, etc. The forming of the electrical pattern of the heating zones, i.e., an electrically isolated, resistive heater path, may be done by techniques known in the art, including but not limited to micro machining, micro-brading, laser cutting, chemical etching, or e-beam etching.

Referring back to Figure 1, the apparatus 100 includes a cover plate 110 defining upper surface 112 and a base plate 120. In accordance with the present invention, the apparatus includes a thermal leveler, such as a TPG based leveler disposed in between the cover plate and the base plate. The thermal leveler is detachable from the apparatus and can be removed from the apparatus as desired. For example, the thermal leveler may be removed from the apparatus when the surface 112 is deemed to be no longer suitable for use in the desired heating operation. The leveler can be removed and subsequently transferred to another apparatus configured to receive and secure the thermal leveler.

The thermal leveler is releasably detachable from the apparatus. The thermal leveler may be associated with or secured in the apparatus by any suitable fastener or fastening mechanism. This may include, but is not limited to, clamps, bolts, threads, cam locks, retaining grooves, retaining rings, a spring, a vacuum, electrostatic forces, electromagnetic forces, magnetic forces, an adhesive, a solder, a paste, etc. In the case of adhesive type fasteners (e.g., adhesives, solder, pastes, etc.), the adhesive fastener should be such that the adhesive fastener can be "reflowed" to a sufficient extent to allow for the leveler to be detached from the cover plate and/or the base plate.

Figures 2-7 illustrate different embodiments of apparatuses in accordance with aspects of the invention. Figure 2 shows an embodiment of an apparatus 200 having a cover plate 210 and a base plate 220. A thermal leveler 230 is disposed between the cover plate and the base plate. The apparatus is held together by pins 240. The pins may be formed as part of the underside of the cover plate. In another embodiment, the pins may be formed as part of the base plate and extend from an upper surface thereof. The pins are disposed through holes in the thermal leveler and can lock into recesses in the base plate (or cover plate) as designed.

Figure 3 shows an apparatus 300 having a cover plate 310, a base plate 320, and a thermal leveler 330 disposed between the cover plate 310 and the base plate 320. The cover plate is secured to the base plate via threaded fasteners 340. The cover plate and thermal leveler are configured with apertures through which the fastener may be inserted, and the base plate is configured with a threaded slot 322 to receive the thread portion of the fastener. The cover plate may be configured such that a portion of the aperture is sized to allow for the head of the fastener to be flush or recessed relative to the upper surface 312 of the cover plate. It will be appreciated that the configuration could be reversed such that the cover plate includes a threaded recessed portion configured to receive a threaded fastener inserted through apertures in the base plate and the thermal leveler.

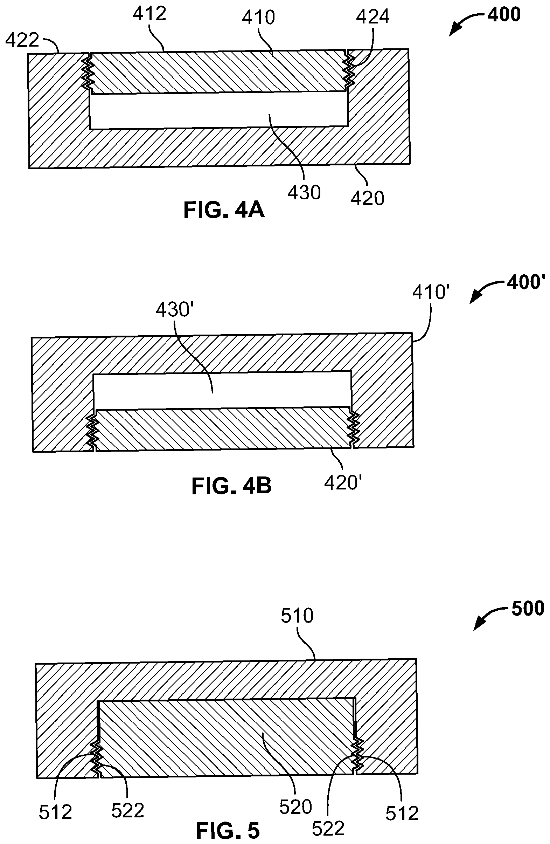

Figure 4a shows an apparatus 400 having a cover plate 410, a base plate 420, and a thermal leveler 430 disposed between the cover plate and the base plate. In the embodiment of Figure 4a, the base plate includes an opening through which the thermal leveler may be inserted and positioned within the base plate. The base plate includes a threaded opening 424 configured to receive the cover plate having a threaded surface to mate with the threaded portion of the base plate. In this embodiment, the base plate is such that it has an upper surface 422 that is coextensive with the upper surface 412 of the cover plate when the cover plate is fastened to the base plate thereby forming the overall upper surface of the apparatus.

It will be appreciated that this configuration could be reversed as shown in Figure 4b, and the apparatus 400' could be configured such that the cover plate 410' fits over top of the thermal leveler 430' that rests on the base plate 420'. The base plate 420' and the cover plate 410' are configured with threads and the apparatus can be secured by threading engagement of the cover plate 410' and the base plate 420'.

Figure 5 shows an apparatus 500 comprising only a cover plate 510 and a thermal leveler 520. The cover plate and the thermal leveler are configured with threads 512 and 522 to allow for threading engagement of the cover plate to the thermal leveler.

Figure 6 shows an apparatus 600 comprising a cover plate 610, a base plate 620, and a thermal leveler 630 disposed between the cover plate and the base plate. The apparatus includes a cam lock system to secure the cover plate to the base plate and hold the thermal leveler in place. The cam lock system includes a pin or dowel 640 and a cam 650 to engage and interlock with the dowel. The dowel can have a thread adapted to be threaded into a recess 622 in the base plate.

The cover plate, thermal leveler, and/or base plate can be configured with additional features that can serve to provide additional support, centering, or locking capabilities. For example, a surface of the thermal leveler can be provided with a slot that can receive a protrusion defined in surface of the cover plate and or the base plate. Referring to Figure 7, an apparatus 700 includes a cover plate 710, a base plate 720, and a thermal leveler 730 disposed between the cover plate and the base plate. The surface 732 of the thermal leveler includes a slot or recessed area 734, and the surface 712 of the cover plate that engages the surface 732 of the thermal leveler includes a protrusion 714 configured to fit into the slot 734 of the thermal leveler. Again, it will be appreciated that the opposing surface of the thermal leveler and the upper surface of the base plate could be configured with such profiles to allow for similar engagement. The shape and/or number of such features is generally not limited and can be selected as desired for a particular purpose or intended application.

The thermal leveler comprises thermal pyrolytic graphite. The configuration of the thermal leveler is not particularly limited and can be selected as desired for a particular application or end use. In particular, the configuration of the thermal leveler will be chosen to provide a desired thermal profile. The TPG layer may be embedded in the heater of the invention as a single layer by itself, or in one embodiment for a heater with a metal substrate, the TPG layer can be in an encapsulated form, e.g., a TPG core encapsulated within a structural metallic shell. Encapsulated TPG is commercially available from Momentive Performance Materials Inc. as TC1050^{®} encapsulated TPG. TPG can be incorporated into the heater as a contiguous single sheet, or, in one embodiment, a plurality of smaller TPG pieces in an overlapping/mosaic configuration. Figures 8a-8d show cross-sectional views of examples of thermal leveler configurations. In Figure 8a, the thermal leveler 800a is a sheet of TPG. In Figure 8b, the thermal leveler 800b comprises a sheet of TPG 810b disposed between a metal or ceramic upper layer 820b and a metal or ceramic lower layer 830b. In Figure 8c, the thermal leveler 800c includes a sheet of TPG 810c encapsulated by a metal or ceramic layer 820c.

The orientation and number of TPG sheets in the thermal leveler is not particularly limited. The number, orientation, and position of the sheets can be selected as desired to provide a particular thermal profile. As shown in Figure 8d, a thermal leveler 800d is shown with a TPG sheet 810d and 820d disposed or encased in a metal or ceramic 830d.

Figures 9a-9c illustrate top views of embodiments of different thermal leveler configurations. In Figure 9a, the thermal leveler 900a comprises a TPG sheet 910a. In Figure 9b, the thermal leveler 900b comprises a central TPG sheet 910b, and a TPG sheet 920b defining a ring around the perimeter of the thermal leveler. In figure 9c, the TPG sheets 910c, 920c, and 930c are provided as triangular shapes with a space between adjacent sheets. Again, these are merely examples of possible configurations for the TPG sheet in the thermal leveler. The number, shape and orientation of the sheets may be selected as desired to provide a desired thermal profile. Further the thermal profile can be configured by the orientation of the planes of the graphene layers in the TPG sheet (e.g., providing the sheet such that the graphene planes are oriented parallel to the surface of the sheet or perpendicular to the surface of the sheet.

The thermal leveler can also be provided with grooves. The grooves may be provided to receive a gas, o-ring, fluid, heater attachment, cooler attachment, etc. Figure 10 illustrates a thermal leveler 1000 having grooves 1010 disposed in a surface of the thermal leveler. In Figure 10, the thermal leveler is generically shown as a block. It will be appreciated that the grooves could be in the surface of the TPG material if the thermal leveler is formed from the TPG itself, or the grooves could be disposed in the metal or ceramic layer if the TPG sheet is disposed between or encased by metal or ceramic material. The grooves could also be provided in any surface of the thermal leveler as desired.

The TPG in the thermal leveler is not particularly limited. TPG may be may be used interchangeably with "highly oriented pyrolytic graphite" ("HOPG"), or compression annealed pyrolytic graphite ("CAPG"). TPG is extremely thermally conductive with an in-plane (a-b direction) thermal conductivity greater than 1000 W/m-K, while the thermal conductivity in the out-of-plane (z-direction) is in the range of 5 to 30 W/m-K. In one embodiment, TPG has an in-plane thermal conductivity greater than 1,500 W/m-K. In one embodiment, the TPG layer has a thickness ranging from about 0.5 mm to 15 mm with thickness variation (parallelism) within 0.005 mm. In another embodiment, the TPG layer has a thickness in the range of 1 mm to 10 mm. In a third embodiment, the TPG layer has a thickness in the range of 2 to 8 mm.

In one embodiment, the TPG is held in place and embedded within the thermal leveler simply by the adhesion of the underlying substrate and/or overcoat where they make contact. In another embodiment, the TPG (in a pure TPG sheet form, or as an encapsulated TPG core in a metal casing, as pure thermal pyrolytic graphite in small piece sizes such as rectangular, square pieces; in random sizes; or in "strips") is glued in place using a high-temperature adhesive known in the art.

The outer layers or encapsulating layer of a thermal leveler can be selected as desired to contribute to the desired thermal profile of the leveler. The outer layers or encapsulating layer of the thermal leveler can be, for example a metal or ceramic material. Examples of suitable materials for coating, covering, and/or encasing the TPG include, but are not limited to, aluminum, copper, silver, gold, nickel, beryllium, tin, lead and steel or an alloy thereof or a composite such as Kovar, copper-tungsten, copper-molybdenum, Invar, Inconel, Hastelloy, aluminum-beryllium and tin-lead, an oxide, nitride, carbide, carbonitride or oxynitride of elements selected from a group consisting of B, Al, Si, Ga, Y, refractory hard metals, transition metals; oxide, oxynitride of aluminum.

The cover plate and/or the base plate can be formed from any suitable material as desired for a particular purpose or intended application. The cover and/or base plate may form part of a heater configuration. The cover and/or base plate may be formed from a metal or a ceramic material. Examples of suitable metals include, but are not limited to, high temperature materials such as, copper or aluminum alloy. Examples of suitable ceramic materials include, but are not limited to, an oxide, nitride, carbide, carbonitride or oxynitride of elements selected from a group consisting of B, Al, Si, Ga, Y, refractory hard metals, transition metals; oxide, oxynitride of aluminum; and combinations thereof.

The base plate or the cover plate can optionally include features to contribute to controlling the temperature of the apparatus. The base plate or the cover plate can include, for example, heater tubes, cooling tubes, or a combination thereof.

Assembly of the apparatus may be accomplished by providing the respective components (e.g., the cover plate, thermal leveler, and optionally the base plate) configured to be secured to one another by a particular fastener or fastening mechanism, attaching the fastener and securing the components together. The apparatus is similarly dismantled by disconnecting the fastener or fastening mechanism. The thermal leveler can be removed from the system and used in a subsequent process or a different thermal leveler can be inserted into the apparatus. If necessary due to decomposition of a part (e.g., wear/decomposition of the cover plate due to exposure to processing conditions), the respective components can be replaced as necessary. Thus, in an embodiment, it may be necessary to replace the cover plate to use in a processing operation.

The apparatus can include other features as desired for a particular purpose or application. In one embodiment, the apparatus includes lifter pins disposed through the base plate and/or the thermal leveler. The cover plate may include recesses to receive the lifter pins pushed through the base plate and/or thermal leveler. The pins engage the cover plate through the recesses and push or separate the cover plate from the apparatus when a force is applied thereto.

The invention is defined by the appended set of claims. Various embodiments from the invention may be considered as long as they belong to the scope of said invention which is defined by the appended set of claims.

Furthermore, to the extent that the term "includes" is used in either the detailed description or the claims, such term is intended to be inclusive in a manner similar to the term "comprising" as "comprising" is interpreted when employed as a transitional word in a claim.

The foregoing description identifies various, non-limiting embodiments of a thermal management assembly. The disclosed embodiments are merely for illustrative purposes and not intended to limit the scope of the invention or the subject matter set forth in the claims.

## Claims

1. An apparatus (100/300/400/400') comprising a thermal leveler (330/430/430') disposed between a cover plate (110/310/410/410') and a base plate (120/320/420/420'), the thermal leveler releasably associated with the cover plate and detachably associated with the base plate, wherein:
(i) the base plate (420) comprises a lower surface, one or more sidewalls extending around the perimeter of the base plate, and an opening defined between the one or more side walls, the thermal leveler (430) disposed within the opening, and the one or more sidewalls having a threaded surface (424) adjacent an upper end of the one or more sidewalls; wherein the cover plate (410) is sized to fit within the opening of the base plate and includes a threaded side surface to engage the threaded surface of the base plate; or
(ii) the base plate (420') comprises an upper surface, a lower surface, and a threaded side surface, the upper surface supporting the thermal leveler (430'); the cover plate (410') includes an upper surface, and one or more side walls extending downwardly from the upper surface of the cover plate and extending around the perimeter thereof, and an opening defined between the one or more side walls and sized to surround the thermal leveler and the base plate, wherein the one or more walls of the cover plate include a threaded surface to engage the threaded surface of the base plate; or
(iii) the cover plate (310) includes one or more apertures; the thermal leveler (330) includes one more apertures aligned with the one or more apertures of the cover plate; and the base plate (320) includes one or more recesses aligned with the one or more apertures of the thermal leveler, wherein the cover plate, thermal leveler, and base plate are releasably connected to one another via fasteners (340) disposed through the one or more apertures of the cover plate and the thermal leveler and the recesses of the base plate.

2. The apparatus of claim 1, wherein the thermal leveler is releasably associated with the cover plate via a clamp, a bolt, a thread, a cam lock, a retaining groove, a retaining ring, a spring, a vacuum, electrostatic forces, electromagnetic forces, magnetic forces, an adhesive, a solder, or a paste.

3. The apparatus of claim 1, wherein in (iii) at least one of the fasteners is a pin that locks into one of the one or more recesses of the base plate.

4. The apparatus of claims 1 or 3, wherein in (iii) at least one of the one or more recesses in the base plate has a threaded surface, and at least one of the fasteners is a threaded fastener suitable for threaded engagement of the at least one or more recesses with the threaded surface.

5. The apparatus of any of claims 1-4, wherein an upper surface of the thermal leveler includes a recess, and a lower surface of the cover plate includes a projection aligned with and sized to mate with the recess in the upper surface of the thermal leveler.

6. The apparatus of any of claims 1-5, wherein the thermal leveler comprises thermal pyrolytic graphite.

7. The apparatus of claim 6, wherein the thermal leveler (a) comprises a sheet of thermal pyrolytic graphite disposed between an upper sheet and a lower sheet, or (b) is encapsulated by a cover layer.

8. The apparatus of claim 7, wherein the upper sheet, the lower sheet, or the cover layer are independently chosen from a metal or ceramic material.

9. The apparatus of claim 8, wherein the upper sheet, the lower sheet, or the cover layer are independently chosen from aluminum, copper, silver, gold, nickel, beryllium, tin, lead, steel, a steel alloy, copper-tungsten, copper-molybdenum, Invar, aluminum-beryllium, tin-lead; an oxide, nitride, carbide, carbonitride or oxynitride of elements selected from a group consisting of B, Al, Si, Ga, Y, refractory hard metals, transition metals.

10. The apparatus of any of claims 1-9, wherein the thermal leveler comprises plural sheets of thermal pyrolytic graphite; optionally wherein the plural sheets of thermal pyrolytic graphite with graphene basal planes parallel or perpendicular to the substrate surface.

11. The apparatus of any of claims 1-10 comprising a plurality of thermal levelers.

12. The apparatus of claim 11, where in the plural thermal levelers comprises thermal pyrolytic graphite with graphene basal planes parallel or perpendicular to the substrate surface.

13. The apparatus of any of claims 1-12, wherein the base plate includes a heater and/or a cooler.

14. The apparatus of any of claims 1-13, wherein the apparatus comprises an electrode disposed therein.

15. A process for heating or cooling a substrate (W) comprising heating or cooling a substrate disposed on the upper surface (112) of the cover plate (110) of the apparatus (100) of any of claims 1-14, the process comprising:
heating the substrate to an end point,
removing the substrate from the apparatus,
releasing the cover plate (110) from the thermal leveler (330/430/430'),
providing a fresh cover plate and releasably connecting it to the thermal leveler, and
providing a second substrate to the apparatus and heating the second substrate.

## Patentansprüche

1. Vorrichtung (100/300/400/400'), umfassend einen thermischen Nivellierer (330/430/430'), der zwischen einer Deckplatte (110/310/410/410') und einer Grundplatte (120/320/420/420') angeordnet ist, wobei der thermische Nivellierer lösbar mit der Abdeckplatte und abnehmbar mit der Grundplatte verbunden ist, wobei:
(i) die Grundplatte (420) eine untere Oberfläche, eine oder mehrere Seitenwände, die sich um den Umfang der Grundplatte erstrecken, und eine zwischen der einen oder mehreren Seitenwänden definierte Öffnung umfasst, wobei der thermische Nivellierer (430) innerhalb der Öffnung angeordnet ist, und die eine oder mehreren Seitenwände eine Gewindefläche (424) angrenzend an ein oberes Ende der einen oder mehreren Seitenwände aufweisen; wobei die Abdeckplatte (410) so dimensioniert ist, dass sie in die Öffnung der Grundplatte passt, und eine mit Gewinde versehene Seitenfläche aufweist, um mit der Gewindefläche der Grundplatte in Eingriff zu kommen; oder
(ii) die Grundplatte (420') eine obere Fläche, eine untere Fläche und eine mit Gewinde versehene Seitenfläche umfasst, wobei die obere Fläche den thermischen Nivellierer (430') trägt; die Abdeckplatte (410') eine obere Oberfläche und eine oder mehrere Seitenwände, die sich von der oberen Oberfläche der Abdeckplatte nach unten erstrecken und sich um deren Umfang erstrecken, sowie eine Öffnung, definiert zwischen der einen oder den mehreren Seitenwänden und so bemessen, dass sie den thermischen Nivellierer und die Grundplatte umgibt, einschließt, wobei die eine oder mehreren Wände der Abdeckplatte eine Gewindefläche umfassen, um mit der Gewindefläche der Grundplatte in Eingriff zu kommen; oder
(iii) die Abdeckplatte (310) eine oder mehrere Öffnungen einschließt; der thermische Nivellierer (330) eine oder mehrere Öffnungen, die mit einer oder mehreren Öffnungen der Abdeckplatte ausgerichtet sind, einschließt; und die Grundplatte (320) eine oder mehrere Aussparungen einschließt, die mit der einen oder den mehreren Öffnungen des thermischen Nivellierers ausgerichtet sind, wobei die Abdeckplatte, der thermische Nivellierer und die Grundplatte lösbar miteinander verbunden sind über Befestigungselemente (340), angeordnet durch die eine oder mehreren Öffnungen der Deckplatte und den thermischen Nivellierer und die Aussparungen der Grundplatte.

2. Vorrichtung nach Anspruch 1, wobei der thermische Nivellierer über eine Klemme, einen Bolzen, ein Gewinde, eine Nockensperre, eine Haltenut, einen Haltering, eine Feder, ein Vakuum, elektrostatische Kräfte, elektromagnetische Kräfte, magnetische Kräfte, einen Klebstoff, ein Lot oder eine Paste lösbar mit der Abdeckplatte verbunden ist.

3. Vorrichtung nach Anspruch 1, wobei in (iii) mindestens eines der Befestigungselemente ein Stift ist, der in einer der einen oder mehreren Aussparungen der Grundplatte einrastet.

4. Vorrichtung nach Anspruch 1 oder 3, wobei in (iii) mindestens eine der einen oder mehreren Aussparungen in der Grundplatte eine Gewindeoberfläche aufweist und mindestens eines der Befestigungselemente ein Gewindebefestigungselement ist, geeignet für den Gewindeeingriff der mindestens einen oder mehreren Aussparungen mit der Gewindefläche.

5. Vorrichtung nach einem der Ansprüche 1 bis 4, wobei eine obere Oberfläche des thermischen Nivellierers eine Aussparung einschließt und eine untere Oberfläche der Abdeckplatte einen Vorsprung einschließt, ausgerichtet mit und so dimensioniert, sich mit der Aussparung in der oberen Oberfläche des thermischen Nivellierers zu paaren.

6. Vorrichtung nach einem der Ansprüche 1 bis 5, wobei der thermische Nivellierer thermischen pyrolytischen Graphit umfasst.

7. Vorrichtung nach Anspruch 6, wobei der thermische Nivellierer (a) eine Lage aus thermisch pyrolytischem Graphit umfasst, die zwischen einer oberen Lage und einer unteren Lage angeordnet ist, oder (b) durch eine Deckschicht eingekapselt ist.

8. Vorrichtung nach Anspruch 7, wobei die obere Lage, die untere Lage oder die Deckschicht unabhängig voneinander aus einem Metall- oder Keramikmaterial ausgewählt sind.

9. Vorrichtung nach Anspruch 8, wobei die obere Lage, die untere Lage oder die Deckschicht unabhängig voneinander ausgewählt sind aus Aluminium, Kupfer, Silber, Gold, Nickel, Beryllium, Zinn, Blei, Stahl, einer Stahllegierung, Kupfer-Wolfram, Kupfer-Molybdän, Invar, Aluminium-Beryllium, Zinn-Blei; einem Oxid, Nitrid, Carbid, Carbonitrid oder Oxynitrid von Elementen, ausgewählt aus einer Gruppe, bestehend aus B, Al, Si, Ga, Y, feuerfesten Hartmetallen, Übergangsmetallen.

10. Vorrichtung nach einem der Ansprüche 1 bis 9, wobei der thermische Nivellierer mehrere Schichten aus thermisch pyrolytischem Graphit umfasst; optional wobei die mehreren Lagen aus thermisch pyrolytischem Graphit mit Graphen-Basisebenen parallel oder senkrecht zur Substratoberfläche sind.

11. Vorrichtung nach einem der Ansprüche 1-10, umfassend mehrere thermische Nivellierer.

12. Vorrichtung nach Anspruch 11, wobei die mehreren thermischen Nivellierer thermischen pyrolytischen Graphit mit Graphen-Basisebenen umfassen, die parallel oder senkrecht zur Substratoberfläche verlaufen.

13. Vorrichtung nach einem der Ansprüche 1-12, wobei die Grundplatte eine Heizung und/oder einen Kühler umfasst.

14. Vorrichtung nach einem der Ansprüche 1-13 , wobei die Vorrichtung eine darin angeordnete Elektrode umfasst.

15. Verfahren zum Erhitzen oder Kühlen eines Substrats, umfassend das Erhitzen oder Kühlen eines Substrats (W), das auf der oberen Oberfläche (112) der Abdeckplatte (110) der Vorrichtung (100) nach einem der Ansprüche 1-14 angeordnet ist, wobei das Verfahren umfasst:
Erhitzen des Substrats bis zu einem Endpunkt,
Entfernen des Substrats aus der Vorrichtung,
Lösen der Abdeckplatte (1109) von dem thermischen Nivellierer (330/430/430'),
Bereitstellen einer frischen Abdeckplatte und deren lösbares Verbinden mit dem thermischen Nivellierer, und
Bereitstellen eines zweiten Substrats für die Vorrichtung und Erhitzen des zweiten Substrats.

## Revendications

1. Appareil (100/300/400/400') comprenant un niveleur thermique (330/430/430') disposé entre une plaque de recouvrement (110/310/410/410') et une plaque de base (120/320/420/420'),
le niveleur thermique étant associé de manière à pouvoir être libéré à la plaque de recouvrement et associé de manière amovible à la plaque de base, dans lequel :
(i) la plaque de base (420) comprend une surface inférieure, une ou plusieurs parois latérales s'étendant autour du périmètre de la plaque de base, et une ouverture définie entre la ou les parois latérales, le niveleur thermique (430) étant disposé au sein de l'ouverture, et la ou les parois latérales ayant une surface filetée (424) adjacente à une extrémité supérieure de la ou des parois latérales ; dans lequel la plaque de recouvrement (410) est dimensionnée pour s'ajuster au sein de l'ouverture de la plaque de base et inclut une surface latérale filetée pour s'engager avec la surface filetée de la plaque de base ; ou
(ii) la plaque de base (420') comprend une surface supérieure, une surface inférieure, et une surface latérale filetée, la surface supérieure supportant le niveleur thermique (430') ; la plaque de recouvrement (410') inclut une surface supérieure, et une ou plusieurs parois latérales s'étendant vers le bas depuis la surface supérieure de la plaque de recouvrement et s'étendant autour du périmètre de celle-ci, et une ouverture définie entre la ou les parois latérales et dimensionnée pour entourer le niveleur thermique et la plaque de base, dans lequel la ou les parois de la plaque de recouvrement incluent une surface filetée pour s'engager avec la surface filetée de la plaque de base ; ou
(iii) la plaque de recouvrement (310) inclut une ou plusieurs ouvertures ; le niveleur thermique (330) inclut une ou plusieurs ouvertures alignées avec la ou les ouvertures de la plaque de recouvrement ; et la plaque de base (320) inclut un ou plusieurs retraits alignés avec la ou les ouvertures du niveleur thermique, dans lequel la plaque de recouvrement, le niveleur thermique et la plaque de base sont connectés l'un à l'autre de manière à pouvoir être libérés par le biais de pièces de fixation (340) disposées à travers la ou les ouvertures de la plaque de recouvrement et le niveleur thermique et les retraits de la plaque de base.

2. Appareil selon la revendication 1, dans lequel le niveleur thermique est associé de manière à pouvoir être libéré à la plaque de recouvrement par le biais d'une bride, d'un boulon, d'un filet, d'un cylindre à excentrique, d'une rainure de retenue, d'un anneau de retenue, d'un ressort, d'un vide, de forces électrostatiques, de forces électromagnétiques, de forces magnétiques, d'un adhésif, d'une brasure, ou d'une pâte.

3. Appareil selon la revendication 1, dans lequel dans (iii) au moins une des pièces de fixation est une broche qui se verrouille dans un du ou des retraits de la plaque de base.

4. Appareil selon la revendication 1 ou 3, dans lequel dans (iii) au moins un du ou des retraits dans la plaque de base a une surface filetée, et au moins une des pièces de fixation est une pièce de fixation filetée convenant à l'engagement fileté des au moins un ou plusieurs retraits avec la surface filetée.

5. Appareil selon l'une quelconque des revendications 1 à 4, dans lequel une surface supérieure du niveleur thermique inclut un retrait, et une surface inférieure de la plaque de recouvrement inclut une saillie alignée avec le et dimensionnée pour se conjuguer au retrait dans la surface supérieure du niveleur thermique.

6. Appareil selon l'une quelconque des revendications 1 à 5, dans lequel le niveleur thermique comprend du graphite pyrolytique thermique.

7. Appareil selon la revendication 6, dans lequel le niveleur thermique (a) comprend une feuille de graphite pyrolytique thermique disposée entre une feuille supérieure et une feuille inférieure, (b) est encapsulé par une couche de recouvrement.

8. Appareil selon la revendication 7, dans lequel la feuille supérieure, la feuille inférieure ou la couche de recouvrement sont indépendamment choisies parmi un matériau métallique ou céramique.

9. Appareil selon la revendication 8, dans lequel la feuille supérieure, la feuille inférieure ou la couche de recouvrement sont indépendamment choisies parmi de l'aluminium, du cuivre, de l'argent, de l'or, du nickel, du béryllium, de l'étain, du plomb, de l'acier, un alliage d'acier, du cuivre-tungstène, du cuivre-molybdène, de l'invar, de l'aluminium-béryllium, de l'étain-plomb ; un oxyde, nitrure, carbure, carbonitrure ou oxynitrure d'éléments sélectionnés parmi un groupe constitué de B, Al, Si, Ga, Y, métaux durs réfractaires, métaux de transition.

10. Appareil selon l'une quelconque des revendications 1 à 9, dans lequel le niveleur thermique comprend une pluralité de feuilles de graphite pyrolytique thermique ; en option dans lequel la pluralité de feuilles de graphite pyrolytique thermique avec des plans basaux de graphène parallèles ou perpendiculaires à la surface de substrat.

11. Appareil selon l'une quelconque des revendications 1 à 10, comprenant une pluralité de niveleurs thermiques.

12. Appareil selon la revendication 11, dans lequel la pluralité de niveleurs thermiques comprend du graphite pyrolytique thermique avec des plans basaux de graphène parallèles ou perpendiculaires à la surface de substrat.

13. Appareil selon l'une quelconque des revendications 1 à 12, dans lequel la plaque de base inclut un élément chauffant et/ou un refroidisseur.

14. Appareil selon l'une quelconque des revendications 1 à 13, dans lequel l'appareil comprend une électrode disposée en son sein.

15. Procédé de chauffage ou refroidissement d'un substrat (W) comprenant chauffer ou refroidir un substrat disposé sur la surface supérieure (112) de la plaque de recouvrement (110) de l'appareil (100) selon l'une quelconque des revendications 1 à 14, le procédé comprenant :
chauffer le substrat à un point d'extrémité,
retirer le substrat de l'appareil,
libérer la plaque de recouvrement (110) du niveleur thermique (330/430/430'),
fournir une nouvelle plaque de recouvrement et la connecter de manière à pouvoir être libérée au niveleur thermique, et
fournir un second substrat à l'appareil et chauffer le second substrat.
